# EUROPEAN PATENT APPLICATION

(11) **EP 2 216 830 A1**
(43) Date of publication of application: **11.08.2010**
(21) Application number: 08853694.1
(22) Date of filing: 28.10.2008
(51) Int. Cl.: H01L 31/05

(54) **SOLAR BATTERY MODULE AND SOLAR BATTERY MODULE MANUFACTURING METHOD**

(30) Priority: 30.11.2007 JP 2007310833
(71) Applicant: Sharp Kabushiki Kaisha, Osaka-shi Osaka 545-8522 (JP)
(72) Inventor: ISONO, Nobuyuki, Osaka-shi, Osaka 545-8522 (JP); YAMAMOTO, Masahito, Osaka-shi, Osaka 545-8522 (JP)
(74) Representative: Müller - Hoffmann & Partner
(86) International application number: PCT/JP2008/069518
(87) International publication number: WO 2009/069415

(57) **Abstract**

A solar cell module 1 is formed by connecting solar cell connected bodies 3 to each other via a conductor bar 15, the solar cell connected bodies each including a plurality of solar cells 11 connected to each other with an intercellular wiring member 21. The conductor bar 15 and the solar cell connected body 3 are connected to each other with a connecting member 26 that is a provided with a step 27 having the same height as the difference in height between a connecting portion of the conductor bar 15 and a connecting portion of the solar cell connected body 3.

## Description

### Technical Field

The present invention relates to a solar cell module in which solar cell connected bodies are connected via a conductor bar, the solar cell connected bodies each made up of connected solar cells and a method for manufacturing such a solar cell module.

### Background Art

In recent years, there are increasing expectations for clean energy in consideration of global environmental conservation issues, such as global warming, and attention is given to solar cell modules, which convert solar energy directly into electrical energy, as a clean energy source.

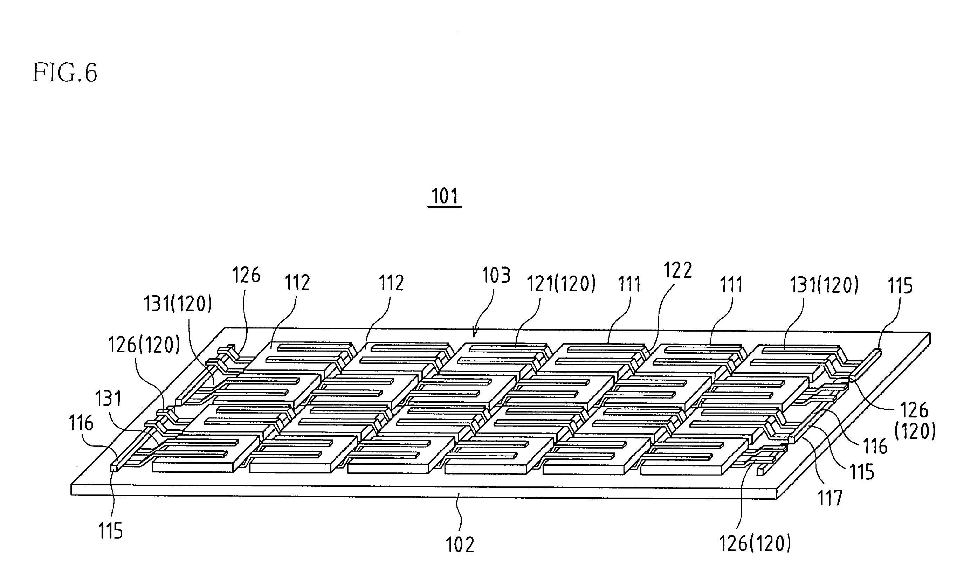

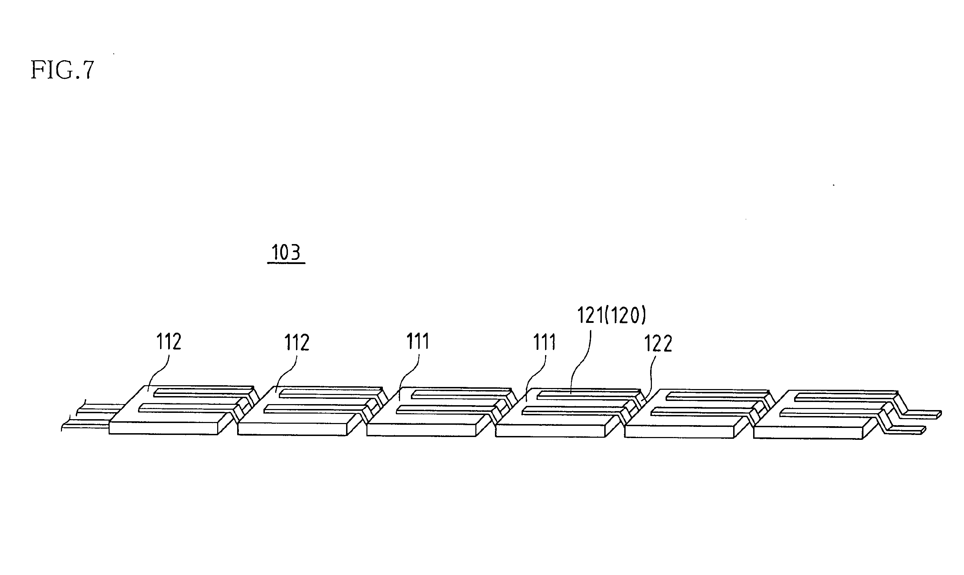

FIG. 6 is a perspective view of a solar cell module according to Conventional Example 1. FIG. 7 is a perspective view of a solar cell connected body of the solar cell module shown in FIG. 6.

A solar cell module 101 includes solar cell connected bodies 103 each made up of a plurality of connected solar cells 111, conductor bars 115 that connect such solar cell connected bodies 103 to each other, and a glass substrate 102 that holds the solar cell connected bodies 103 that are connected.

Solar cells 111 included in a solar cell connected body 103 are connected with a wiring member 120 that is referred to as an "interconnector". Specifically, in adjacent solar cells 111, a surface electrode (an electrode disposed on the glass substrate 102 side) of one of the solar cells 111 and a back surface electrode 112 of the other solar cell 111 are connected with a wiring member. As the wiring member, a solder-dipped copper foil in the form of a ribbon is used, and the connection between the electrode of the solar cell 111 and the wiring member 120 is performed by solder bonding.

There are primarily two methods to connect solar cells 111 with a wiring member 120.

The first method is to connect the surface electrode and back surface electrode 112 of solar cells 111 that are disposed adjacent to each other with a single wiring member 120 (see, for example, Patent Document 1).

The second method is to connect solar cells 111 that are disposed adjacent to each other with two wiring members, wherein a wiring member connected to the surface electrode of one of the solar cells 111 and a wiring member connected to the back surface electrode of the other solar cell are connected (see, for example, Patent Document 2).

In both methods, because the wiring members 120 are used to connect the surface electrode of one solar cell 111 and the back surface electrode 112 of another solar cell 111, each wiring member 120 extending between the electrodes is provided, midway, with a step 122 having the same height as the difference in height between the electrode positions. By providing such a step 122, it is possible to reduce the pressing force applied to the solar cell 111 due to the elasticity of the wiring member itself as compared to that when the solar cells 111 are connected with a wiring member without a step, whereby damage to the solar cell 111 is reduced, as a result of which the failure rate can be reduced.

The connection between solar cells 111 with a wiring member 120 is performed as follows.

First, a metal wire material as a base material for the wiring member 120 is fed from a reel. The metal wire material drawn from the reel is cut to a specified length, and a step having a specified height is provided by using a die, whereby a wiring member 120 is formed. Then, one end (the end located higher than the other end) of the wiring member 120 is brought into contact with the back surface electrode of a solar cell 111, and the other end is disposed away from the solar cell 111 so that another solar cell 111 can be mounted thereon.

The solar cell 111 on which the wiring member 120 has been disposed is conveyed to a location where a solar cell 111 on which a wiring member 120 was disposed previously in the same manner as described above is in a waiting state, and then mounted on the other end (the end located lower than the one end) of the wiring member 120 disposed on the solar cell 111 in a waiting state. At this time, the solar cell 111 is disposed such that the surface electrode thereof comes into contact with the wiring member 120 of the solar cell 111 in a waiting state.

Subsequently, the solar cells 111 having the wiring member 120 disposed thereon are conveyed to a heating step. Because solder plating has been performed on the surface electrode and the back surface electrode 112 of the solar cells 111, each electrode and the wiring member 120 are solder-connected by the application of heat. Through the above-described steps, a plurality of solar cells 111 are connected with wiring members 120, and a solar cell connected body 103 is formed.

Solar cell connected bodies 103 formed as described above are connected via a conductor bar 115. In addition, the solar cell connected bodies 103 are connected in series. Incidentally, the leading ends (the end portions that are not connected to the electrodes) of the wiring members 120 disposed at the end of two solar cell connected bodies 103 that are connected to each other with a conductor bar 115 have different heights. Accordingly, the wiring members 120 and the conductor bar 115 are connected at the surface 117 and the back surface 116 of the conductor bar 115 (see FIG. 6). Specifically, the surface electrode of the solar cell 111 disposed at an end of one of two solar cell connected bodies 103 is connected to the back surface 116 of the conductor bar 115 with the wiring member 120, and the back surface electrode 112 of the solar cell 111 disposed at an end of the other solar cell connected body 103 is connected to the surface of the conductor bar 115 with the wiring member 120.

Hereinafter, in order to distinguish the wiring member 120 that connects solar cells and the wiring member 120 that connects a solar cell 111 and a conductor bar 115 from each other, the wiring member that connects solar cells is referred to as an "intercellular wiring member 121", and the wiring member 120 that connects a solar cell 111 and a conductor bar 115 is referred to as a "connecting member". In addition, of such connecting members, the connecting member that connects the surface electrode of a solar cell 111 and a conductor bar 115 is referred to as a "first connecting member 126", and the connecting member that connects the back surface electrode 112 of a solar cell 111 and a conductor bar 115 is referred to as a "second connecting member 131".
[Patent Document 1] JP 2004-363293A
[Patent Document 2] JP 2002-359388A

### Disclosure of Invention

### Problems to be Solved by the Invention

However, as described above, because when connecting two solar cell connected bodies 103 to a conductor bar 115, a first connecting member 126 is connected to the back surface 116 of the conductor bar 115, and a second connecting member 131 is connected to the surface 117 of the conductor bar 115, it is necessary to turn over one of the solar cell connected bodies 103 after the other solar cell connected body 103 has been connected, resulting in a problem that the work performance is low. There is also a possibility that the solar cell connected body 103 might be damaged when it is turned over. Furthermore, there is another problem in that a good external appearance is not obtained because the first connecting member 126 and the second connecting member 131 are soldered to the back surface 116 and surface 117 of the conductor bar 115, respectively.

In order to solve such problems, a method has been proposed in which the second connecting member 131 is bent and then disposed on the back surface of the conductor bar 115 so that both the first connecting member 126 and the second connecting member 131 are disposed on the back surface 116 of the conductor bar 115.

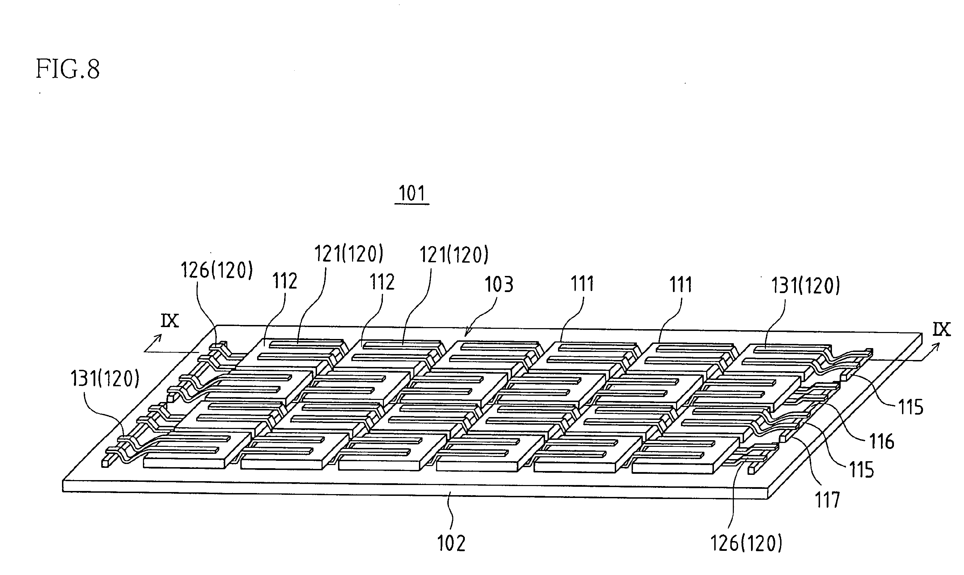

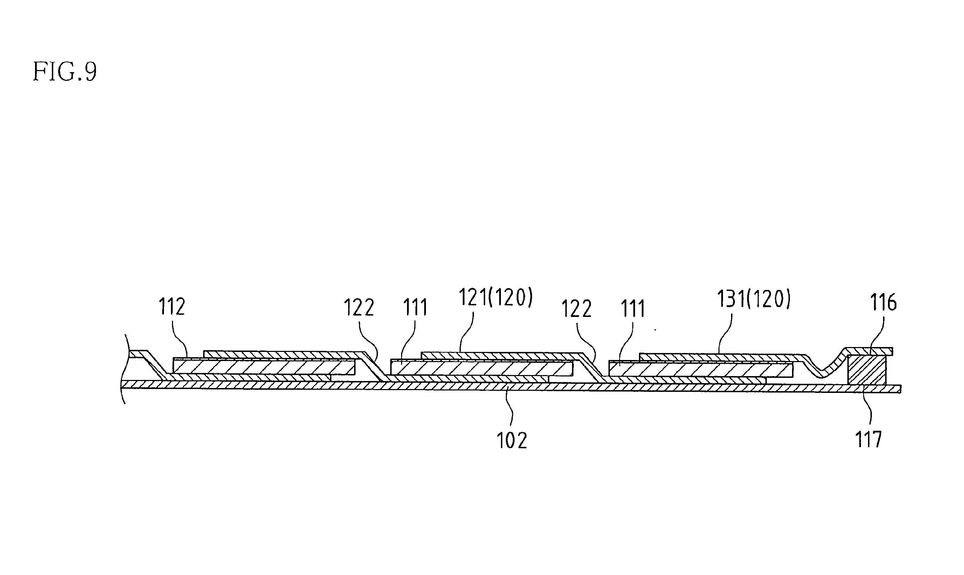

FIG. 8 is a perspective view of a solar cell module according to Conventional Example 2 in which both a first connecting member and a second connecting member are connected to the back surface of a conductor bar. FIG. 9 is a cross-sectional view taken along the line IX-IX of FIG. 8.

According to this method, it is unnecessary to turn over the solar cell connected bodies 103, and the connection between the first connecting member 126 and the conductor bar 115 and the connection between the second connecting member 131 and the conductor bar 115 can be performed from one direction, as a result of which improved work efficiency can be obtained.

However, it is necessary to bend the second connecting member 131, which conversely requires more time (see FIG. 9).

In addition, when deforming the second connecting member 131, a force is applied to the second connecting member 131 and a portion corresponding to the back surface electrode 112 of the solar cell 111, and so there is a possibility that a fracture or crack may occur in the bonding portion. Furthermore, there is a problem in that if the second connecting member 131 is not deformed as designed, stress is applied to the solar cell 111 when connecting the second connecting member 131 and the conductor bar 115 with solder, and a fracture, crack or the like occurs in the solar cell 111.

As a method for solving the problem, a method has been proposed in which instead of connecting the first connecting member 126 and the second connecting member 131 to respective electrodes of the solar cells 111 in the step of connecting solar cells 111 with an intercellular wiring member 121, in a separate step, the first connecting member 126 and the second connecting member 131 are disposed between the solar cell connected body 103 and the conductor bar 115, and then connected. In this separate step, first, the first connecting member 126 and the conductor bar 115, and the second connecting member 131 and the conductor bar 115 are connected, and after that, the first connecting member 126 and the back surface electrode 112 of the solar cell 111, and the second connecting member 131 and the surface electrode of the solar cell 111 are connected.

According to this method, because the first connecting member 126 and the second connecting member 131 are not connected to any of the solar cells 111 and the conductor bar 115 at the start, the first connecting member 126 and the second connecting member 131 can be disposed without causing stress, and so the application of stress on the solar cell 111 during soldering can be suppressed.

However, this method has a problem in that it is necessary to dispose the first connecting member 126 and the second connecting member 131 in a separate step, and a problem in that the production efficiency is lowered due to the additional step of soldering. There is also a problem in that, in addition to the application of heat in the step of connecting solar cells 111 with an intercellular wiring member 121, heat is applied when connecting the solar cell connected bodies 103 and the conductor bar 115 in the separate step, or in other words, heat stress is applied twice to the solar cells 111, as a result of which damage such as a fracture or a crack occurs easily in the solar cell connected bodies 103.

The present invention has been conceived in view of the above circumstances, and it is an object of the present invention to provide a solar cell module that can be manufactured without lowering the production efficiency thereof, and that has a structure in which no stress remains in the solar cells, and a method for manufacturing such a solar cell module.

### Means for solving the Problems

A solar cell module according to the present invention is a solar cell module in which solar cell connected bodies are connected to each other via a conductor bar, the solar cell connected bodies each including a plurality of solar cells connected to each other with an intercellular wiring member, wherein the conductor bar and the solar cell connected body are connected to each other with a connecting member that is provided with a step having the same height as a difference in height between a connecting portion of the conductor bar and a connecting portion of the solar cell connected body.

With the solar cell module of the present invention, because the conductor bar and the solar cell connected body are connected to each other with the connecting member provided with a step having the same height as the difference in height between the connecting portion of the conductor bar and the connecting portion of the solar cell connected body, no stress will occur between the connecting member and the connecting portion of the solar cell connected body as well as between the connecting member and the conductor bar. Accordingly, a solar cell module in which no stress remains in the connecting portions of the connecting member can be obtained.

In addition, because the connecting member is provided with a step having the same height as the difference in height between the connecting portion of the conductor bar and the connecting portion of the solar cell connected body, it is not necessary to perform a task, such as deforming the connecting member, when connecting the connecting member and the conductor bar. Accordingly, it is possible to manufacture solar cell modules without lowering the production efficiency.

In addition, according to the solar cell module of the present invention, a difference in height between connecting portions of the solar cells differs from a difference in height between the connecting portion of the solar cell connected body and the connecting portion of the conductor bar, the solar cells are connected to each other with the intercellular wiring member that is provided with a step having the same height as the difference in height between the connecting portions of the solar cells, and the solar cell connected body and the conductor bar are connected to each other with the connecting member provided with a step having the same height as the difference in height between the connecting portion of the conductor bar and the connecting portion of the solar cell connected body.

With the solar cell module of the present invention, in the case of a type in which there is the difference in height between the connecting portions of solar cells, and between the connecting portion of a solar cell connected body and the connecting portion of a conductor bar, the solar cells are connected to each other with an intercellular wiring member that is provided with a step having the same height as the difference in height between the connecting portions of the solar cells, and the conductor bar and the solar cell connected body are connected to each other with a connecting member that is provided with a step having the same height as the difference in height between the connecting portion of the conductor bar and the connecting portion of the solar cell connected body. Accordingly, it is possible to obtain a solar cell module in which both a stress in the connection between the connecting portion of the solar cell and the intercellular wiring member and a stress in the connection between the connecting portion of the solar cell connected body and the conductor bar do not remain.

In addition, a solar cell module according to another aspect of the present invention is a solar cell module in which solar cell connected bodies are connected to each other via a conductor bar, the solar cell connected bodies each including a plurality of solar cells connected to each other with an intercellular wiring member, wherein a surface electrode of the solar cell disposed at an end of one of the solar cell connected bodies and a back surface-side connecting portion of the conductor bar are connected to each other with a first connecting member that is provided with a step having the same height as a difference in height between the surface electrode of the solar cell and the back surface-side connecting portion of the conductor bar, and a back surface electrode of the solar cell disposed at an end of another solar cell connected body and the back surface-side connecting portion of the conductor bar are connected to each other with a second connecting member that is provided with a step having the same height as a difference in height between the back surface electrode of the solar cell and the back surface-side connecting portion of the conductor bar, whereby the solar cell connected bodies are electrically connected in series via the conductor bar.

With the solar cell module of the present invention, solar cell connected bodies are connected to each other with a connecting member (a first connecting member or a second connecting member) provided with a step having the same height as the difference in height between the connecting portion of the solar cell connected body and the back surface-side connecting portion of the conductor bar, and both connecting portions of the conductor bar are provided on the back surface side. Accordingly, when connecting the solar cell connected body and the conductor bar, soldering can be performed from the back surface side without turning over the solar cell connected body, as a result of which soldering can be performed easily in the manufacturing process. In addition, a good external appearance can be presented when viewed from the surface side (the side on which the surface electrode of the solar cell is disposed). Furthermore, a solar cell module in which no stress remains in the connection between the connecting portion of the solar cell connected body and the conductor bar can be obtained.

In addition, a solar cell module according to another aspect of the present invention is a solar cell module in which solar cell connected bodies are connected to each other via a conductor bar, the solar cell connected bodies each including a plurality of solar cells connected to each other with an intercellular wiring member, wherein a surface electrode of the solar cell disposed at an end of one of the solar cell connected bodies and a back surface-side connecting portion of the conductor bar are connected to each other with a first connecting member that is provided with a step having the same height as a difference in height between the surface electrode of the solar cell and the back surface-side connecting portion of the conductor bar, and a back surface electrode of the solar cell disposed at an end of another solar cell connected body and the back surface-side connecting portion of the conductor bar that has the same height as the back surface electrode are connected to each other with a flat second connecting member in which there is no step, whereby the solar cell connected bodies are electrically connected in series via the conductor bar.

With the solar cell module of the present invention, because each solar cell connected body is connected to the back surface-side connecting portion of the conductor bar, when connecting the solar cell connected body and the conductor bar, soldering can be performed from the back surface side without turning over the solar cell connected body, and therefore soldering can be performed easily in the manufacturing process. In addition, a good external appearance can be presented when viewed from the surface side (the side on which the surface electrode of the solar cell is disposed).

In addition, for the connection between the surface electrode of the solar cell disposed at an end of the solar cell connected body and the back surface-side connecting portion of the conductor bar, a first connecting member provided with a step having the same height as the difference in height between the surface electrode of the solar cell and the back surface-side connecting portion of the conductor bar is used, and for the connection between the back surface electrode of the solar cell disposed at an end of the solar cell connected body and the back surface-side connecting portion of the conductor bar that is the same height as the back surface electrode, a flat second connecting member in which there is no step is used. Accordingly, it is possible to obtain a solar cell module in which both a stress in the connection between the surface electrode of the solar cell and the back surface-side connecting portion of the conductor bar, and a stress in the connection between the back surface electrode of the solar cell and the back surface-side connecting portion of the conductor bar do not remain.

In addition, a solar cell module manufacturing method according to the present invention is a method for manufacturing a solar cell module by forming solar cell connected bodies, each of which is formed by connecting a plurality of solar cells to each other with an intercellular wiring member, and connecting the solar cell connected bodies to each other via a conductor bar, wherein the intercellular wiring member that connects the solar cells is provided with a step having the same height as a difference in height between a connecting portion of one solar cell and a connecting portion of another solar cell, and thereafter the intercellular wiring member is disposed between the solar cells to connect the solar cells, and a connecting member that connects the conductor bar and a solar cell connected body is provided with a step having the same height as a difference in height between a connecting portion of the solar cell connected body and a connecting portion of the conductor bar, or is made flat without providing a step when there is no difference in height between the connecting portion of the solar cell connected body and the connecting portion of the conductor bar, and thereafter the connecting member is disposed between the solar cell connected body and the conductor bar to connect the conductor bar and the solar cell connected body.

According to the present invention, when connecting solar cells by using an intercellular wiring member and when connecting a solar cell connected body and a conductor bar by using a connecting member in the solar cell module manufacturing process, respectively, the intercellular wiring member is provided with a step having the same height as the difference in height between the connecting portions of the solar cells to be connected to each other, and the connecting member is provided with a step having the same height as the difference in height between the connecting portion of the solar cell connected body and the connecting portion of the conductor bar, or is made flat without providing a step when there is no difference in height between the connecting portion of the solar cell connected body and the connecting portion of the conductor bar (or in other words, when the connecting portion of the solar cell connected body and the connecting portion of the conductor bar have an equal height). Thereafter, the intercellular wiring member and the connecting member are disposed in a location where they are connected to each other. Accordingly, even when connecting portions having the height difference are connected, it is not necessary to perform a task, such as deforming the connecting member, when connecting the connecting member and the conductor bar. Consequently, it is possible to manufacture solar cell modules without lowering the production efficiency.

In addition, because it is unnecessary to deform the connecting member during the connecting step, no stress is applied to the connection, and therefore it is possible to manufacture solar cell modules in which no stress remains in the solar cells.

### Effects of the Invention

The solar cell module of the present invention is configured such that a conductor bar and a solar cell connected body are connected to each other with a connecting member provided with a step having the same height as the difference in height between the connecting portions of these members, as a result of which no stress occurs between the connecting member and the connecting portion of the solar cell connected body as well as between the connecting member and the conductor bar. Accordingly, a solar cell module in which no stress remains in the connecting portions of the connecting member can be obtained.

In addition, because the connecting member is provided with a step having the same height as the difference in height between the connecting portion of the conductor bar and the connecting portion of the solar cell connected body, it is not necessary to perform a task, such as deforming the connecting member, when connecting the connecting member and the conductor bar. Accordingly, it is possible obtain a solar cell module that can be manufactured without lowering the production efficiency.

According to the solar cell module manufacturing method of the present invention, when connecting solar cells by using an intercellular wiring member and when connecting a solar cell connected body and a conductor bar using a connecting member in the solar cell module manufacturing process, respectively, the intercellular wiring member is provided with a step having the same height as the difference in height between the connecting portions of the solar cells to be connected to each other, and the connecting member is provided with a step having the same height as the difference in height between the connecting portion of the solar cell connected body and the connecting portion of the conductor bar, or is made flat without providing a step when the connecting portion of the solar cell connected body and the connecting portion of the conductor bar have an equal height. Thereafter, the intercellular wiring member and the connecting member are disposed in a location where they are connected to each other. Accordingly, even when connecting portions having the height difference are connected, it is not necessary to perform a task, such as deforming the connecting member, when connecting the connecting member and the conductor bar. Consequently, it is possible to manufacture solar cell modules without lowering the production efficiency.

In addition, because it is unnecessary to deform the connecting member during the connecting step, no stress is applied to the connection, and therefore it is possible to manufacture solar cell modules in which no stress remains in the solar cells.

### Brief Description of Drawings

[FIG. 1] FIG. 1 is an enlarged view of an end portion of a solar cell module according to an embodiment of the present invention.
[FIG. 2] FIG. 2 is a cross-sectional view taken along the line II-II of FIG. 1.
[FIG. 3] FIG. 3 is a cross-sectional view taken along the line III-III of FIG. 1.
[FIG. 4] FIG. 4 is an explanatory diagram illustrating an example in which a solar cell connected body and a conductor bar are connected with a flat connecting member.
[FIG. 5] FIG. 5 is an explanatory diagram illustrating a solar cell connected body manufacturing apparatus that manufactures solar cell connected bodies according to a solar cell module manufacturing method of an embodiment of the present invention.
[FIG. 6] FIG. 6 is a perspective view of a solar cell module according to Conventional Example 1.
[FIG. 7] FIG. 7 is a perspective view of a solar cell connected body of the solar cell module shown in FIG. 6.
[FIG. 8] FIG. 8 is a perspective view of a solar cell module according to Conventional Example 2 in which both a first connecting member and a second connecting member are connected to the back surface of a conductor bar.
[FIG. 9] FIG. 9 is a cross-sectional view taken along the line IX-IX of FIG. 8.

### Description of Reference Numerals

- 1: Solar Cell Module
- 2: Glass Substrate
- 3: Solar Cell Connected Body
- 11: Solar Cell
- 12: Back Surface Electrode of Solar Cell
- 15: Conductor Bar
- 16: Back Surface of Conductor Bar
- 21: Intercellular Wiring Member
- 22: Step Provided in Intercellular Wiring Member
- 23: First Connecting Portion of Intercellular Wiring Member
- 24: Second Connecting Portion of Intercellular Wiring Member
- 26: First Connecting Member (Connecting Member)
- 27: Step Provided in First Connecting Member
- 28: Surface Electrode Connecting Portion of First Connecting Member
- 29: Conductor Bar Connecting Portion of First Connecting Member
- 31: Second Connecting Member (Connecting Member)
- 32: Step Provided in Second Connecting Member
- 33: Back Surface Electrode Connecting Portion of Second Connecting Member
- 34: Conductor Bar Connecting Portion of Second Connecting Member
- 40: Solar Cell Connected Body Manufacturing Apparatus
- 41: Metal Wire Material Feed Reel
- 42: Metal Wire Material Processing Part
- 43: Solar Cell Connected Body Forming Part
- 45: Change-Direction Roller
- 46: Return Roller
- 47: Regulating Chuck
- 48: Cutting Die
- 49: Transfer Chuck
- 51: Step forming Unit
- 60: Metal Wire Material

### Best Mode for Carrying Out the Invention

Hereinafter, an embodiment of the present invention will be described with reference to the drawings.

### Solar Cell Module

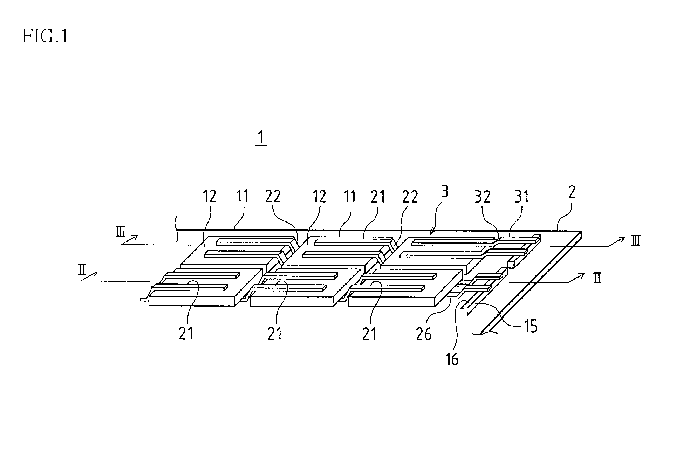

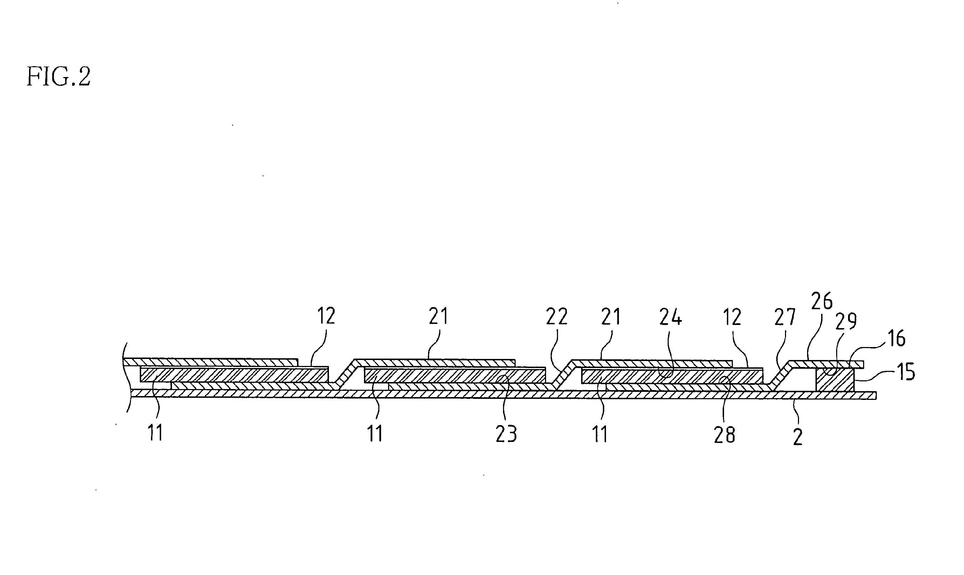

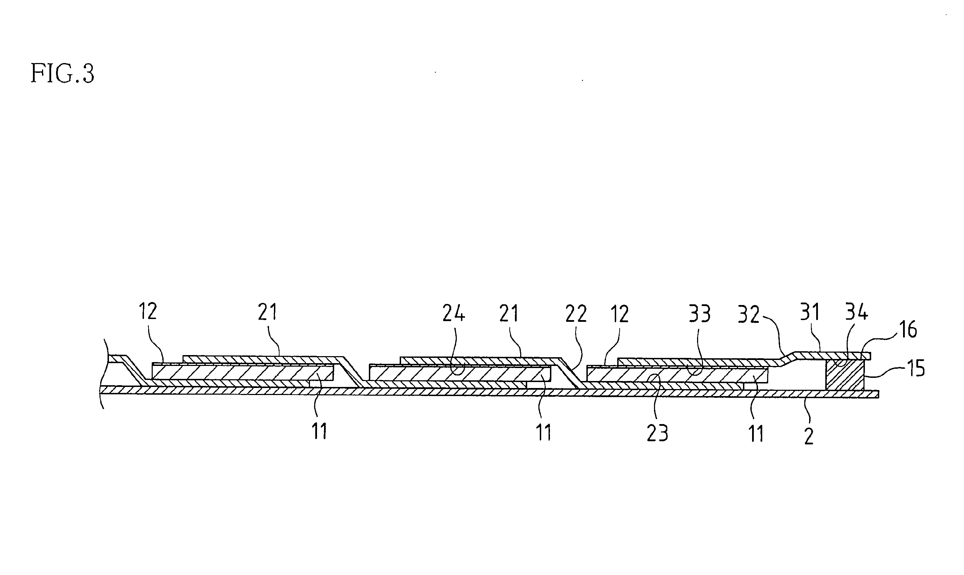

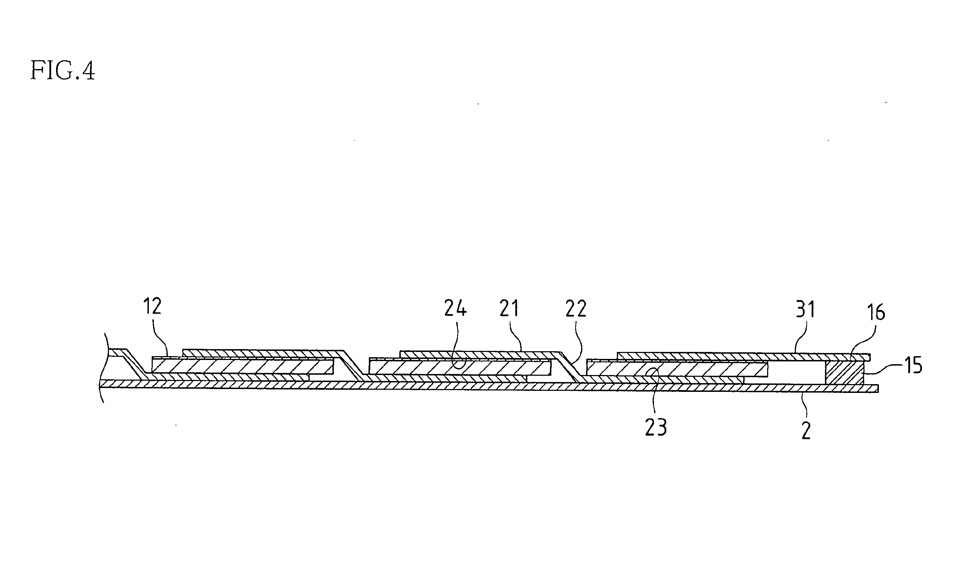

FIG. 1 is an enlarged view of an end portion of a solar cell module according to the present embodiment. FIG. 2 is a cross-sectional view taken along the line II-II of FIG. 1. FIG. 3 is a cross-sectional view taken along the line III-III of FIG. 1. FIG. 4 is an explanatory diagram illustrating an example in which a solar cell connected body and a conductor bar are connected with a flat connecting member.

A solar cell module 1 of the present embodiment includes a solar cell connected body 3 in which a plurality of solar cells 11 are connected to each other with intercellular wiring members 21, a conductor bar 15 that connects such solar cell connected bodies 3 to each other, and a glass substrate 2 that holds the solar cell connected bodies 3 that are connected.

In a solar cell 11, a surface electrode is formed on the light-receiving surface side of a semiconductor substrate, and a back surface electrode 12 is formed on the back surface side. The thickness of the solar cell 11 is 150 to 200 µm. The surface electrode is formed into a comb-shape that improves the current collecting efficiency and power generation efficiency. The back surface electrode 12 is formed so as to cover the entire back surface in order to reduce the connection resistance. In the surface electrode, at least a connecting portion to which an intercellular wiring member 21 or connecting member, which will be described later, is connected is solder-plated. Likewise, in the back surface electrode 12 as well, at least a connecting portion to which an intercellular wiring member 21 or connecting member, which will be described later, is connected is solder-plated. This is performed to enable reflow solder connection.

The solar cell connected body 3 is formed by electrically connecting solar cells 11 in series with intercellular wiring members 21.

An intercellular wiring member 21 is disposed between solar cells 11 to connect the solar cells 11. Specifically, the intercellular wiring member 21 is made, for example, of a solder-plated copper member in the form of a ribbon. One end of the intercellular wiring member 21 serves as a connecting portion (hereinafter referred to as a "first connecting portion 23") that is connected to the surface electrode of a solar cell 11, and the other end serves as a connecting portion (hereinafter referred to as a "second connecting portion 24") that is connected to the back surface electrode 12 of another solar cell 11.

In addition, a step 22 is provided between the first connecting portion 23 and the second connecting portion 24. The step 22 has the same height as the difference in height between the surface electrode of one of the solar cells 11 that are connected to each other and the back surface electrode 12 of the other solar cell 11.

The connection between solar cell connected bodies 3 is performed via a conductor bar 15 for connecting the solar cells 11 disposed at the end of the solar cell connected bodies 3.

The connection between the solar cell connected body 3 and the conductor bar 15 is performed with a connecting member. The solar cell connected bodies 3 are connected to each other in series. Specifically, the surface electrode of the solar cell 11 disposed at an end of one solar cell connected body 3 and the back surface (connecting portion) 16 of the conductor bar 15 are connected with a connecting member (hereinafter referred to as a "first connecting member 26"), and the back surface electrode 12 of the solar cell 11 disposed at an end of another solar cell connected body 3 and the back surface (connecting portion) 16 of the conductor bar 15 are connected with a connecting member (hereinafter referred to as a "second connecting member 31"). In other words, the surface electrode of the solar cell 11 disposed at an end of one solar cell connected body 3 and the back surface electrode 12 of the solar cell 11 disposed at an end of another solar cell connected body 3 are connected via a conductor bar 15.

As shown in FIG. 2, one end of the first connecting member 26 serves as a connecting portion (hereinafter referred to as a "surface electrode connecting portion 28") that is connected to the surface electrode of a solar cell 11, and the other end serves as a connecting portion (hereinafter referred to as a "conductor bar connecting portion 29") that is connected to the back surface 16 of the conductor bar 15 (the connecting portion of the conductor bar 15). The first connecting member 26 is made, for example, of a solder-plated copper member in the form of a ribbon.

In the first connecting member 26, a step 27 is provided between the surface electrode connecting portion 28 and the conductor bar connecting portion 29. The step 27 has the same height as the difference in height between the surface electrode of the solar cell 11 disposed at an end of one solar cell connected body 3 and the back surface (connecting portion) 16 of the conductor bar 15 (the height difference between the surface electrode of the solar cell 11 and the back surface 16 of the conductor bar 15).

As shown in FIG. 3, one end of the second connecting member 31 serves as a connecting portion (hereinafter referred to as a "back surface electrode connecting portion 33") that is connected to the back surface electrode of a solar cell 11, and the other end serves as a connecting portion (hereinafter referred to as a "conductor bar connecting portion 34") that is connected to the back surface 16 of the conductor bar 15 (the connecting portion of the conductor bar 15). The second connecting member 31 is made, for example, of a solder-plated copper member in the form of a ribbon, as in the first connecting member 26.

In addition, in the second connecting member 31, a step 32 is provided between the back surface electrode connecting portion 33 and the conductor bar connecting portion 34. The step 32 has the same height as the difference in height between the back surface electrode 12 of the solar cell 11 disposed at an end of the other solar cell connected body 3 and the back surface (connecting portion) 16 of the conductor bar 15 (the height difference between the back surface electrode 12 of the solar cell 11 and the back surface 16 of the conductor bar 15).

If there is no difference in height between the back surface electrode 12 of the solar cell 11 and the back surface of the conductor bar 15 (if the back surface electrode 12 of the solar cell 11 and the back surface of the conductor bar 15 have an equal height), the second connecting member 31 is made flat without providing a step as shown in FIG. 4.

The connection between the solar cell connected body 3 and the intercellular wiring member 21 and the connection between the solar cell connected body 3 and the conductor bar 15 are not limited to solder connection, and it may be, for example, connection using a conductive paste or the like.

According to the above configuration, in the solar cell module 1, the conductor bar 15 and the solar cell connected bodies 3 are connected to each other with the first connecting member 26 and the second connecting member 31 that are provided with a step having the same height as the difference in height between the conductor bar 15 and the solar cell connected body 3. Accordingly, no stress is generated between the first connecting member 26 and the surface electrode of the solar cell 11, between the second connecting member 31 and the back surface electrode 12 of the solar cell 11, between the first connecting member 26 and the back surface of the conductor bar 15, and between the second connecting member 31 and the back surface 16 of the conductor bar 15. Accordingly, a solar cell module 1 in which no stress remains in the connecting portions of the connecting members can be obtained.

In addition, because the first connecting member 26 and the second connecting member 31 are provided with a step having the same height as the difference in height between the conductor bar 15 and the connecting portion of the solar cell connected body 3, it is unnecessary to perform a task, such as deforming the first connecting member 26 and the second connecting member 31, when connecting the first connecting member 26 and the conductor bar 15 and when connecting the second connecting member 31 and the conductor bar 15. Accordingly, with this configuration, it is possible to manufacture solar cell modules 1 without lowering the production efficiency.

In addition, in such a solar cell module 1, in the case of a type in which there is the difference in height between the surface electrode and back surface electrode 12 of adjacent solar cells 11, and between the surface electrode of a solar cell 11 and the back surface 16 of the conductor bar 15, the solar cells 11 are connected to each other with an intercellular wiring member 21 provided with a step 22 having the same height as the difference in height between the surface electrode and back surface electrode 12 of the solar cells 11, on the other hand, the conductor bar 15 and a solar cell connected body 3 are connected to each other with a first connecting member 26 provided with a step 27 having the same height as the difference in height between the back surface of the conductor bar 15 and the surface electrode of the solar cell 11 disposed at an end of the solar cell connected body 3, and the conductor bar 15 and another solar cell connected body 3 are connected to each other with a second connecting member 31 provided with a step 32 having the same height as the difference in height between the back surface 16 of the conductor bar 15 and the back surface electrode 12 of the solar cell 11 disposed at an end of the solar cell connected body 3. Accordingly, it is possible to obtain a solar cell module 1 in which both a stress in the connection between the electrode of the solar cell 11 and the intercellular wiring member 21, and a stress in the connection between the electrode of the solar cell 11 disposed at an end of the solar cell connected body 3 and the first connecting member 26 or the second connecting member 31 do not remain.

In addition, in such a solar cell module 1, in the case of a type in which the back surface electrode 12 of the solar cell 11 disposed at an end of a solar cell connected body 3 and the back surface 16 of the conductor bar 15 have an equal height, the conductor bar 15 and the solar cell 11 disposed at an end of the solar cell connected body 3 are connected to each other with a flat second connecting member 31 without a step. Accordingly, it is possible to obtain a solar cell module 1 in which no stress remains in the connection between the back surface electrode 12 of the solar cell 11 and the back surface 16 of the conductor bar 15.

In addition, in the solar cell module 1, both the connecting portion of the conductor bar 15 to which the first connecting member 26 is connected and the connecting portion of the conductor bar 15 to which the second connecting member 31 is connected are provided on the back surface side, and the solar cell connected bodies 3 are connected to each other with a first connecting member 26 or second connecting member 31 provided with a step having the same height as the difference in height between the electrode of the solar cell connected body 3 and the back surface 16 of the conductor bar 15. Accordingly, when connecting the solar cell connected body 3 and the conductor bar 15, soldering can be performed from the back surface side without turning over the solar cell connected body 3, as a result of which soldering can be performed easily in the manufacturing process, a good external appearance can be presented when viewed from the surface side (the side on which the surface electrode of the solar cell 11 is disposed), and a solar cell module 1 in which no stress remains in the connection between the solar cell 11 at an end of the solar cell connected body 3 and the conductor bar 15 can be obtained.

### Method for Manufacturing Solar Cell Module

A method for manufacturing a solar cell module 1 will be described.

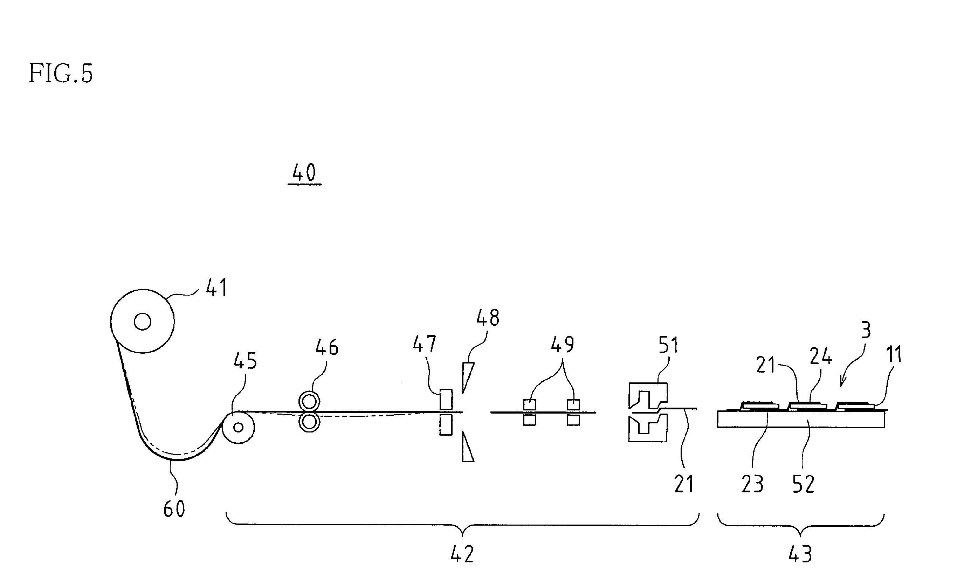

FIG. 5 is an explanatory diagram illustrating a solar cell connected body manufacturing apparatus that manufactures solar cell connected bodies.

A solar cell module 1 is manufactured by forming solar cell connected bodies 3 and connecting the solar cell connected bodies 3 via a conductor bar 15.

A solar cell connected body manufacturing apparatus 40 that forms solar cell connected bodies 3 includes a metal wire material feed reel 41 around which a metal wire material 60, which is a base material for an intercellular wiring member 21, a first connecting member 26 and a second connecting member 31, is wound, a metal wire material processing part 42 that forms an intercellular wiring member 21, a first connecting member 26 and a second connecting member 31, and a solar cell connected body forming part 43 that connects solar cells 11 so as to form a solar cell connected body 3.

As the metal wire material 60, a 150 to 200 µm thick copper foil in the form of a ribbon that has been solder-dipped or solder-plated is used.

The metal wire material feed reel 41 is controlled so as to rotate according to the feed amount of the metal wire material 60. In addition, the rotation is controlled such that no excessive tensile force is applied to the metal wire material 60 and that the metal wire material 60 is always slackened a certain amount in the region in which the metal wire material 60 is drawn from the metal wire material feed reel 41. With this configuration, the occurrence of twisting, deformation and the like that can occur when feeding the metal wire material 60 is prevented.

The metal wire material processing part 42 is a part in which the metal wire material 60 fed from the metal wire material feed reel 41 is cut to a connection unit length, and a step is provided by using a step forming die so as to form an intercellular wiring member 21, a first connecting member 26 or a second connecting member 31 (hereinafter also referred to as an "intercellular wiring member or the like").

The metal wire material processing part 42 includes a change-direction roller 45 that changes the traveling direction of the metal wire material 60 to the horizontal direction, return rollers 46 that correct the slack in the metal wire material 60 by rotating such that the metal wire material 60 is pulled back to the direction of the change-direction roller 45, a regulating chuck 47 that regulates the leading end of the metal wire material 60, a cutting die 48 that cuts the metal wire material 60 into a connection unit length, a transfer chuck 49 that transfers the unit length metal wire material 60, and a step forming unit 51 that forms an intercellular wiring member or the like by pressing the unit length metal wire material 60 to form a step.

The step forming unit 51 includes three types of dies: an intercellular step forming die that forms a step 22 for an intercellular wiring member 21; a first step-forming die that forms a step 27 for a first connecting member 26; and a second step-forming die that forms a step 32 for a second connecting member 31 that are configured so as to be driven in sync with the timing at which the step 22 of the intercellular wiring member 21, the step 27 of the first connecting member 26 or the step 32 of the second connecting member 31 is formed.

In the metal wire material processing part 42, the metal wire material 60 is processed according to the following steps.

The metal wire material 60 fed from the metal wire material feed reel 41 is made horizontal by the change-direction roller 45, and transferred to a specified position by a transfer roller (not shown) and the metal wire material feed reel 41 that rotates in cooperation with the rotation of the transfer roller. Then, the metal wire material 60 is cut to a unit length by the cutting die 48. The unit length metal wire material 60 is held by the transfer chuck 49 and transferred to the step forming unit 51.

Subsequently, a step is formed around the midway point of the metal wire material 60 so as to form an intercellular wiring member or the like. Specifically, in the case of forming an intercellular wiring member 21, a step 22 is formed by the intercellular step forming die. In the case of forming a first connecting member 26, a step 27 is formed by the first step-forming die. In the case of forming a second connecting member 31, a step 32 is formed by the second step-forming die.

The second connecting member 31 is provided with a step 32 having a height according to a difference in the height position between the back surface electrode 12 of the solar cell 11 and the back surface 16 of the conductor bar 15, but when the height positions are the same between the back surface electrode 12 of the solar cell 11 and the back surface of the conductor bar 15, it is unnecessary to provide such a step in the second connecting member 31, and therefore, in such a case, the formation of a step is not performed.

The solar cell connected body forming part 43 is a part in which a solar cell connected body 3 is formed by mounting the intercellular wiring member or the like on a solar cell 11 and connecting solar cells 11, and includes a mounting part (not shown) that mounts the intercellular wiring member or the like on a solar cell 11, a conveying stage 52 that conveys the solar cell 11, and a heating unit (not shown) that heats a plurality of solar cells 11 and the intercellular wiring member or the like to connect them.

In the conveying stage 52, solar cells 11 to be connected are mounted one by one. Accordingly, the conveying stage 52 is configured such that the whole body (connected solar cells 11) is moved by the length of a solar cell 11 each time one solar cell is connected. Specifically, the conveying stage 52 is configured of, for example, a belt conveyor.

In the solar cell connected body forming part 43, a solar cell connected body 3 is formed in the following manner.

A first connecting member 26 is formed from the metal wire material 60 fed from the metal wire material feed reel 41, and the first connecting member 26 is disposed on the conveying stage 52.

Subsequently, a solar cell 11 is supplied from a solar cell supply unit (not shown) by a grapnel, and mounted on the surface electrode connecting portion 28 of the first connecting member 26.

An intercellular wiring member 21 is formed from the metal wire material 60 fed from the metal wire material feed reel 41. The intercellular wiring member 21 is disposed at a specified position with respect to the solar cell 11 disposed on the conveying stage 52. Specifically, the intercellular wiring member 21 is mounted such that the second connecting portion 24 is disposed on the back surface electrode 12 of the solar cell 11 and the first connecting portion 23 is disposed on the conveying stage 52.

Furthermore, another solar cell 11 is supplied from the solar cell supply unit by the grapnel, and mounted on the first connecting portion 23 of the intercellular wiring member 21. Then, the connected group in which the solar cells 11 are connected is moved by the length of a single solar cell 11.

The disposition of an intercellular wiring member 21 and the disposition of a solar cell 11 are performed by the number of solar cells required to constitute a connected group.

After the last solar cell 11 has been disposed, a second connecting member 31 is disposed at a specified position. Specifically, the second connecting member 31 is mounted such that the back surface electrode connecting portion 33 is disposed on the back surface electrode 12 of the solar cell 11.

The solar cell connected body in which a plurality of solar cells 11 are connected is introduced into the heating unit. Each electrode and intercellular wiring member or the like are solder-connected by the application of heat.

Next, the connection between solar cell connected bodies 3 will be described.

Solar cell connected bodies 3 are disposed in parallel with an equal spacing therebetween. The solar cell connected bodies 3 are disposed in opposite directions to each other. In other words, the solar cell connected bodies 3 are disposed such that the solar cell connected bodies 3 are electrically connected in series by being connected to a conductor bar 15.

Subsequently, the conductor bar 15 is disposed at both ends of the solar cell connected bodies 3. Then, the conductor bar connecting portion 29 of the first connecting member 26 extending from one end of one of the solar cell connected bodies 3 and the back surface 16 of the conductor bar 15 is solder-connected, and the conductor bar connecting portion 34 of the second connecting member 31 extending from one end of the other solar cell connected body 3 and the back surface 16 of the conductor bar 15 is solder-connected.

Because the first connecting member 26 and the second connecting member 31 are both formed such that the conductor bar connecting portions 29 and 34 are disposed on the back surface 16 of the conductor bar 15, the solder connection between the first connecting member 26 and the conductor bar 15 and the solder connection between the second connecting member 31 and the conductor bar 15 can be performed easily without the need to turn over the solar cell connected body 3 as is required with conventional techniques. In addition, because the connection between the first connecting member 26 and the solar cell 11 and the connection between the second connecting member 31 and the solar cell 11 have been performed in advance, only the connection between the first connecting member 26 and the conductor bar 15, and the connection between the second connecting member 31 and the conductor bar 15 are performed in the solder connecting step, and therefore almost no heat is applied to the solar cells 11 in this step, as a result of which damage due to excessive heat will not occur.

After the solar cell connected bodies 3 have been connected, they are disposed on a glass substrate 2, and sealed with an EVA (ethylene vinyl acetate copolymer), whereby a solar cell module 1 is completed.

According to the method for manufacturing a solar cell module 1 described above, when connecting solar cells 11 by using an intercellular wiring member 21, when connecting a solar cell connected body 3 and a conductor bar 15 by using a first connecting member 26 or a second connecting member 31 in the manufacturing process of the solar cell module 1, respectively, the intercellular wiring member 21 is provided with a step having the same height as the difference in height between the connecting portions of the solar cells 11 to be connected to each other, and the first connecting member 26 and the second connecting member 31 are provided with a step having the same height as the difference in height between the connecting portion of the solar cell connected body 3 and the back surface (connecting portion) 16 of the conductor bar 15, or in the case where there is no difference in height between the connecting portion of the solar cell connected body 3 and the back surface 16 of the conductor bar 15, the second connecting member 31 is made flat without providing a step. Thereafter, the intercellular wiring member 21, the first connecting member 26 and the second connecting member 31 are disposed in a location where they are connected to each other. In other words, because steps are formed in advance in these members before the connection using the first connecting member 26 and the second connecting member 31 is performed, even when portions having the height difference are connected, it is not necessary to perform a task, such as deforming the first connecting member 26 and the second connecting member 31, when connecting the first connecting member 26 and the conductor bar 15 and when connecting the second connecting member 31 and the conductor bar 15. Consequently, it is possible to manufacture solar cell modules 1 without lowering the production efficiency.

In addition, because it is unnecessary to deform the first connecting member 26 and the second connecting member 31 during the connecting step, no stress is applied to the connection, and therefore it is possible to manufacture solar cell modules 1 in which no stress remains in the solar cells 11.

The present invention may be embodied in various other forms without departing from the gist or essential characteristics thereof. Therefore, the embodiment disclosed in this application is to be considered in all respects as illustrative and not limiting. The scope of the invention is indicated by the appended claims rather than by the foregoing description, and all modifications or changes that come within the meaning and range of equivalency of the claims are intended to be embraced therein.

This application claims priority on Japanese Patent Application No. 2007-310833 filed in Japan on November 30, 2007, the entire content of which is incorporated herein by reference.

### Industrial Applicability

The present invention is applicable to a solar cell module that converts solar energy directly into electrical energy and a method for manufacturing such a solar cell module.

## Claims

1. A solar cell module in which solar cell connected bodies are connected to each other via a conductor bar, the solar cell connected bodies each comprising a plurality of solar cells connected to each other with an intercellular wiring member,
wherein the conductor bar and the solar cell connected body are connected to each other with a connecting member that is provided with a step having the same height as a difference in height between a connecting portion of the conductor bar and a connecting portion of the solar cell connected body.

2. A solar cell module according to claim 1,
wherein a difference in height between connecting portions of the solar cells differs from a difference in height between the connecting portion of the solar cell connected body and the connecting portion of the conductor bar,
the solar cells are connected to each other with the intercellular wiring member that is provided with a step having the same height as the difference in height between the connecting portions of the solar cells, and
the solar cell connected body and the conductor bar are connected to each other with the connecting member provided with a step having the same height as the difference in height between the connecting portion of the conductor bar and the connecting portion of the solar cell connected body.

3. A solar cell module in which solar cell connected bodies are connected to each other via a conductor bar, the solar cell connected bodies each comprising a plurality of solar cells connected to each other with an intercellular wiring member,
wherein a surface electrode of the solar cell disposed at an end of one of the solar cell connected bodies and a back surface-side connecting portion of the conductor bar are connected to each other with a first connecting member that is provided with a step having the same height as a difference in height between the surface electrode of the solar cell and the back surface-side connecting portion of the conductor bar, and
a back surface electrode of the solar cell disposed at an end of another solar cell connected body and the back surface-side connecting portion of the conductor bar are connected to each other with a second connecting member that is provided with a step having the same height as a difference in height between the back surface electrode of the solar cell and the back surface-side connecting portion of the conductor bar,
whereby the solar cell connected bodies are electrically connected in series via the conductor bar.

4. A solar cell module in which solar cell connected bodies are connected to each other via a conductor bar, the solar cell connected bodies each comprising a plurality of solar cells connected to each other with an intercellular wiring member,
wherein a surface electrode of the solar cell disposed at an end of one of the solar cell connected bodies and a back surface-side connecting portion of the conductor bar are connected to each other with a first connecting member that is provided with a step having the same height as a difference in height between the surface electrode of the solar cell and the back surface-side connecting portion of the conductor bar, and
a back surface electrode of the solar cell disposed at an end of another solar cell connected body and the back surface-side connecting portion of the conductor bar that has the same height as the back surface electrode are connected to each other with a flat second connecting member in which there is no step,
whereby the solar cell connected bodies are electrically connected in series via the conductor bar.

5. A solar cell module manufacturing method for manufacturing a solar cell module by forming solar cell connected bodies, each of which is formed by connecting a plurality of solar cells to each other with an intercellular wiring member, and connecting the solar cell connected bodies to each other via a conductor bar,
wherein the intercellular wiring member that connects the solar cells is provided with a step having the same height as a difference in height between a connecting portion of one solar cell and a connecting portion of another solar cell, and thereafter the intercellular wiring member is disposed between the solar cells to connect the solar cells, and
a connecting member that connects the conductor bar and a solar cell connected body is provided with a step having the same height as a difference in height between a connecting portion of the solar cell connected body and a connecting portion of the conductor bar, or is made flat without providing a step when there is no difference in height between the connecting portion of the solar cell connected body and the connecting portion of the conductor bar, and thereafter the connecting member is disposed between the solar cell connected body and the conductor bar to connect the conductor bar and the solar cell connected body.
